# EUROPEAN PATENT SPECIFICATION

(11) **EP 2 770 541 B1**
(45) Date of publication and mention of the grant of the patent: **07.09.2016**
(21) Application number: 12842019.7
(22) Date of filing: 19.10.2012
(51) Int. Cl.: H01L 31/042, C08K 5/14, C08L 23/08, C08L 31/04, C08L 33/12, C09K 3/10

(54) **SOLAR CELL SEALING FILM AND SOLAR CELL USING SAME**
VERSIEGELUNGSFILM FÜR SOLARZELLEN UND SOLARZELLE DAMIT
FILM DE SCELLAGE POUR CELLULES SOLAIRES, ET CELLULE SOLAIRE L'UTILISANT

(30) Priority: 21.10.2011 JP 2011231349
(43) Date of publication of application: 27.08.2014
(73) Proprietor: Bridgestone Corporation, Tokyo 104-8340 (JP)
(72) Inventor: KATAOKA Hisataka, Yokohama-shi Kanagawa 244-8510 (JP)
(74) Representative: Oxley, Robin John George
(86) International application number: PCT/JP2012/077061
(87) International publication number: WO 2013/058354

(56) References cited:
- WO-A1-2012/121003
- JP-A- 2006 134 970
- JP-A- 2006 134 970
- JP-A- 2010 153 609
- JP-A- 2010 238 815
- JP-A- 2011 201 928
- JP-A- 2011 201 928

## Description

### Technical Field

The present invention relates to a solar cell sealing film for sealing photovoltaic elements and bonding the components of a solar cell to integrate them, and to a solar cell made using the solar cell sealing film.

### Background Art

In recent years, a solar cell (solar cell module) has been widely employed as a device directly converting solar energy into electric energy from the viewpoints of the effective use of natural resources and the prevention of environmental pollution. Further developments are being made from the viewpoint of productivity and durability.

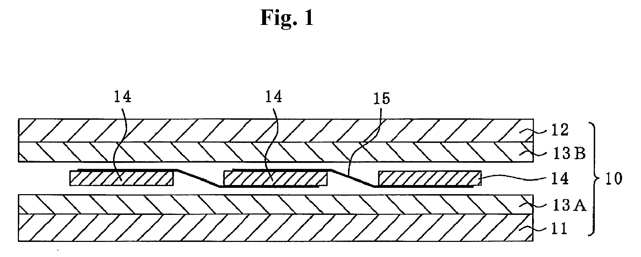

As shown in Fig. 1, a solar cell is generally manufactured by superposing a transparent front side protection material 11 such as a glass plate, a front side sealing film 13A, photovoltaic elements (e.g., photovoltaic elements made of silicon) 14, a backside sealing film 13B and a backside protection material 12 in this order, and degassing them under reduced pressure, and then heating the front side sealing film 13A and the backside sealing film 13B under application of pressure to crosslink and cure the films, whereby they are bonded and integrated. In the solar cell, a plurality of photovoltaic elements 14 are electrically connected with each other by connection tabs 15 in order to generate high electric output.

As the solar cell sealing films (hereinafter, also referred to as "sealing films" for short), films made of ethylene-vinyl acetate copolymer (EVA) are heretofore used because of low cost, high transparency and good adhesion (for example, Patent Document 1). In addition, in order to ensure mechanical durability of photovoltaic elements and prevent occurrence of corrosion of conductive wires and electrodes in the solar cell caused by permeation of moisture or water, the components of the solar cell are bonded with each other by cross-linking the EVA films with crosslinkers to be integrated so as to have high adhesion and bonding strength.

However, EVA comprises vinyl acetate as the constituent and therefore the EVA tends to be hydrolyzed by moisture at high temperature after the installation of the solar cell, which brings about generation of acetic acid over time. The acetic acid may lead to promote occurrence of the corrosion of the conductive wires and electrodes in the solar cell. For this reason, sealing films that are suppressed in acid generation are demanded.

The use of sealing films prepared using EVA having excellent insulation makes it possible to suppress occurrence of leakage current resulting in reduction of power generation efficiency. Recently, solar cells having further enhanced power generation efficiency have been required, and therefore it is required to improve insulation properties of solar cell sealing films. Furthermore, high transparency is desired for the front side sealing film in order to take sunlight into photovoltaic elements without absorbing and reflecting sunlight.

### Prior Art Documents

### Patent Document

Patent Document 1: JP (TOKKAI) 2000-183381 A

### Summary of the Invention

### Problem to be Solved by the Invention

It is therefore an object of the present invention is to provide a solar cell sealing film which is suppressed in acid generation, and which has high transparency and improved insulation properties.

It is a further object of the present invention to provide a solar cell made using the solar cell sealing film.

### Means for Solving Problem

The object is achieved by a solar cell sealing film comprising ethylene-vinyl acetate copolymer (EVA), ethylene-methyl methacrylate copolymer (EMMA), and a crosslinker, wherein a mass ratio of the ethylene-vinyl acetate copolymer to the ethylene-methyl methacrylate copolymer (EVA : EMMA) is in the range of from 10:90 to 90: 10.

The above object is also achieved by a solar cell obtained by sealing photovoltaic elements using this solar cell sealing film.

### Effect of the Invention

The solar cell sealing film of the present invention comprising EVA and EMMA in the above-described amounts is suppressed in acid generation and has excellent insulation properties and transparency, and also has improved hardness after crosslinking. The use of the solar cell sealing film of the present invention gives solar cells having high durability and high power generation efficiency.

### Brief Description of the Drawings

Fig. 1 is a schematic sectional view of a conventional solar cell.

### Description of Embodiments

The present invention is explained in detail below. As described above, the solar cell sealing film of the present invention comprises ethylene-vinyl acetate copolymer (EVA) and ethylene-methyl methacrylate copolymer (EMMA), and the mass ratio (EVA : EMMA) is in the range of from 90:10 to 10:90.

Although it is thought that ethylene-methyl methacrylate copolymer (EMMA), which does not generate acids because of its molecular structure, is used solely in place of EVA, EMMA has poor crosslinking properties. Thus, sealing films of EMMA may lead to reduced hardness for supporting a transparent front side protection material such as a glass plate, and also may not give sufficient transparency due to relatively high haze. The combination of both EVA and EMMA in the above-described amounts brings about solar cell sealing films having suppressed acid generation, high hardness after crosslinking and high transparency. Furthermore, since EMMA has high insulation properties, the solar cell sealing film of the present invention has more excellent insulation properties than that of conventional sealing films.

When the amount of EVA is less (the amount of EMMA is more) than the above-mentioned range, a cure torque value, which is a measure of crosslinking degree, may be reduced, or haze may be increased. When the amount of EMMA is less (the amount of EVA is more) than the above-described range, insufficient insulation is possibly obtained or the amount of acid generated under high temperature and high humidity may be increased.

The mass ratio (EVA: EMMA) is preferably in the range of from 75:25 to 10:90, more preferably from 50:50 to 10:90, particularly preferably from 25:75 to 15:85. When the amount of EMMA is greater than the amount of EVA, very high insulation properties are achieved and sufficient transparency and crosslinking properties required to solar cell sealing films can be ensured.

In the present invention, it is advantageous that a volume resistivity after crosslinking of the solar cell sealing film is not less than 1E+15 Ω·cm, preferably not less than 2E+15 Ω·cm, and a cure torque value after a cross-linking reaction at a temperature of 150°C for 15 minutes is not less than 5 N·cm, preferably not less than 7 N·cm.

The vinyl acetate content of the EVA is preferably in the range of from 20 to 35% by mass, more preferably from 22 to 30% by mass, particularly preferably 24 to 28% by mass. When the content is less than 20% by mass, sufficient transparency may not be obtained. When the content is more than 35% by mass, the amount of acetic acid formed under a condition of high temperature and high humidity may be increased.

The methyl methacrylate content of the EMMA is preferably in the range of from 20 to 35% by mass, more preferably from 22 to 30% by mass, particularly preferably 24 to 28% by mass. When the content is less than 20% by mass, transparency may be reduced. When the content is more than 35% by mass, processability may be reduced.

Each melt flow rate (MFR) of EVA and EMMA is preferably not more than 35 g/10 min, particularly in the range of from 3 to 10 g/10 min. When the MFR falls within these ranges, it is possible to suppress the phenomenon that the sealing film spreads out of a substrate due to its melt or position gap in a heating and pressurizing procedure of the sealing step for preparing a solar cell, thereby obtaining high sealing performance. The value of the Melt Flow Rate (MFR) is determined under the conditions of temperature of 190°C and load of 21.18N according to JIS K 7210.

The solar cell sealing film of the present invention may secondarily contain polyvinyl acetal resin such as polyvinyl formal, polyvinyl butyral (PVB resin) or modified PVB, or vinyl chrolide resin, in addition to EVA and EMMA.

### [Crosslinker]

The solar cell sealing film of the present invention comprises a crosslinker. An organic peroxide or photopolymerization initiator is preferably used as the crosslinker. The organic peroxide is more preferably used because the resultant sealing film is improved in temperature dependencies in adhesion, humidity resistance and penetration resistance.

Any organic peroxides that can be decomposed at a temperature of not less than 100°C to generate radical(s) can be employed as the organic peroxide. The organic peroxide is selected in the consideration of film-forming temperature, conditions for preparing the composition, curing (bonding) temperature, heat resistance of body to be bonded, storage stability. Especially, preferred are those having a decomposition temperature of not less than 70 °C in a half-life of 10 hours.

From the viewpoint of resin processing temperature and storage stability, examples of the organic peroxides include benzoyl peroxide-type cure agents, tert-hexyl peroxypyvalate, tert-butyl peroxypyvalate, 3,5,5-trimethyl hexanoyl peroxide, di-n-octanoyl peroxide, lauroyl peroxide, stearoyl peroxide, 1,1,3,3-tetramethylbutylperoxy-2-ethyl hexanoate, succinic acid peroxide, 2,5-dimethyl-2,5-di(tert-butylperoxy)hexane, 2,5-dimethyl-2,5-di(2-ethylhexanoylperoxy)hexane, 1-cyclohexyl-1-methylethylperoxy-2-ethyl hexanoate, tert-hexylperoxy-2-ethyl hexanoate, 4-methylbenzoyl peroxide, tert-butylperoxy-2-ethyl hexanoate, m-toluoyl+benzoyl peroxide, benzoyl peroxide, 1,1-bis(tert-butylperoxy)-2-methylcyclohexanate, 1,1-bis(tert-hexylperoxy)-3,3,5-trimethylcyclohexanate, 1,1-bis(tert-hexylperoxy)cyclohexanate, 1,1-bis(tert-butylperoxy)-3,3,5-trimethylcyclohexane, 1,1-bis(tert-butylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butylperoxy maleic acid, tert-butylperoxy-3,3,5-trimethyl hexane, tert-butyl peroxylaurate, 2,5-dimethyl-2,5-di(methylbenzoylperoxy)hexane, tert-butylperoxyisopropyl monocarbonate, tert-butylperoxy-2-ethylhexyl monocarbonate, tert-hexyl peroxybenzoate, and 2,5-dimethyl-2,5-di(benzoylperoxy)hexane.

As the benzoyl peroxide-type cure agents, any organic peroxides that can be decomposed at a temperature of not less than 70°C to generate radical(s) can be employed. Especially, preferred are those having a decomposition temperature of not less than 50°C in a half-life of 10 hours. The benzoyl peroxide-type cure agent can be selected in the consideration of conditions for preparing the composition, film-forming temperature, curing (bonding) temperature, and/or heat resistance of body to be bonded, storage stability. Examples of the benzoyl peroxide-type cure agents include benzoyl peroxide, 2,5-dimethylhexyl-2,5-bisperoxy benzoate, p-chlorobenzoyl peroxide, m-toluoyl peroxide, 2,4-dicyclobenzoyl peroxide, t-butylperoxy benzoate. The benzoyl peroxide-type cure agents can be employed singly or in combination of two or more kinds.

The organic peroxides are preferably 2,5-dimethyl-2,5-di(tert-butylperoxy)hexane, 1,1-bis(tert-hexylperoxy)-3,3,5-trimethylcyclohexane, particularly 2,5-dimethyl-2,5-di(tert-butylperoxy)hexane. The use of these organic peroxides results in good crosslinking, and thus the insulation of the solar cell sealing film can be improved.

The organic peroxide is contained in an amount of from 0.1 to 5 parts by mass, preferably from 0.2 to 3 parts by mass, based on 100 parts by mass of the total of EVA and EMMA. If the amount of the organic peroxide is too small, the crosslinking rate at the crosslinking reaction is apt to be reduced. If the amount of the organic peroxide is excessive, the compatibility of the crosslinker with the copolymers is apt to be reduced.

As the photopolymerization initiators, any known photopolymerization initiators can be employed. Preferred are initiators having good storage stability after addition thereof. Examples of the photopolymerization initiators include acetophenone type initiators such as 2-hydroxy-2-methyl-1-phenylpropane-1-on, 1-hydroxycyclohexylphenylketone, 2-methyl-1-[4-(methylthio)phenyl]-2-morphorino-propane-1-on; benzoin type initiators such as benzylmethylketal; and benzophenone type initiators such as benzophenone, 4-phenylbenzophenone and hydroxybenzophenone; thioxan-thone type initiators such as isopropylthioxanthone and 2,4-diethythioxanthone. Further, as special type, there can be mentioned methylphenylglyoxylate. Especially preferred are 2-hydroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed, if necessary, together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds.

The photopolymerization initiator is contained in an amount of from 0.1 to 5 parts by mass, preferably from 0.2 to 3 parts by mass, based on 100 parts by mass of the total of EVA and EMMA.

### [Crosslinking agent]

The solar cell sealing film of the present invention prior to cross-linking may further contain a crosslinking agent. The crosslinking agent enables the enhancement of gel fraction of EVA and EMMA, and the improvement of adhesion and durability of the sealing film.

The crosslinking agent is preferably used in the range of from 0.1 to 5 parts by mass, more preferably from 0.1 to 3 parts by mass, particularly preferably from 0.5 to 2.5 parts by mass, based on 100 parts by mass of the total of EVA and EMMA. The hardness of the resultant sealing films after the crosslinking can thereby be further improved.

Examples of the crosslinking agent (compounds having radical polymerizable groups as functional groups) include trifunctional crosslinking agents such as triallyl cyanurate and triallyl isocyanurate, and mono- or bifunctional crosslinking agents of (meth)acryl esters (e.g., NK Ester, etc.). Among these, triallyl cyanurate and triallyl isocyanurate are preferred. Triallyl isocyanurate is particularly preferred.

### [Adhesion improver]

The solar cell sealing film of the present invention may further comprise an adhesion improver in order to enhance adhesion performance when it is used in a solar cell module. As the adhesion improver, silane coupling agents can be used. Examples of the silane coupling agent include γ-methacryloxypropyltrimethoxysilane, γ-methacryloxypropylmethyldiethoxysilane, γ-methacryloxypropyltriethoxysilane, γ-methacryloxypropylmethyldimethoxysilane, γ-chloropropylmethoxysilane, vinyltriethoxysilane, vinyltris(ß-methoxyethoxy)silane, vinyltriacetoxysilane, γ-glycidoxypropyltrimethoxysilane, γ-glycidoxypropyltriethoxysilane, ß-(3,4-epoxycyclohexyl)ethyltrimethoxysilane, vinyltrichlorosilane, γ-mercaptopropyltrimethoxysilane, γ-aminopropyltriethoxysilane and N-ß-(aminoethyl)- γ-aminopropyltrimethoxysilane.

Of these silane coupling agents, preferred are methacryloxy-type silane coupling agents which are silane coupling agents having a methacryloxy group. Examples of the methacryloxy-type silane coupling agents include γ-methacryloxypropyltrimethoxysilane, γ-methacryloxypropylmethyldiethoxysilane, γ-methacryloxypropyltriethoxysilane, and γ-methacryloxypropylmethyldimethoxysilane. γ-methacryloxypropyltrimethoxysilane is particularly preferred. The silane coupling agent can be employed singly or in combination of two or more kinds.

The silane coupling agent is contained in the solar cell sealing film of the present invention in an amount of not more than 5 parts by mass, preferably from 0.1 to 2 parts by mass, based on 100 parts by mass of the total of EVA and EMMA.

### [Others]

The solar cell sealing film of the invention can contain, if necessary, various additives such as plasticizers, acryloxy group-containing compounds, methacryloxy group-containing compounds and/or epoxy group-containing compounds, for improvement or adjustment of various properties of the film (e.g., mechanical strength, optical characteristics such as transparency, heat resistance, light resistance and cross-linking rate), in particular for improving the mechanical strength.

As the plasticizers, esters of polybasic acids and esters of polyhydric alcohols are generally used. Examples of the esters include dioctyl phthalate, dihexyl adipate, triethylene glycol-di-2-ethylbutylate, butyl sebacate, tetraethylene glycol diheptanoate, triethylene glycol diperalgonate. The plasticizer may be used singly or in combination of two or more kinds. The plasticizer is preferably contained in an amount of not more than 5 parts by mass based on 100 parts by mass of the total of EVA and EMMA.

Examples of the acryloxy or methacryloxy group-containing compounds generally include derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, 3-chloro-2-hydroxypropyl group. Example of the amide includes diacetone acrylamide. Further, examples of the esters include esters of acrylic acid or methacrylic acid with polyhydric alcohol such as ethylene glycol, triethylene glycol, polypropylene glycol, polyethylene glycol, trimethylol propane or pentaerythritol.

Examples of the epoxy group-containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)₅glycidyl ether, p-t-butylphenyl glycidyl ether, diglycidyl adipate, diglycidyl phthalate, glycidyl methacrylate and butyl glycidyl ether.

The content of the acryloxy group-containing compounds, the methacryloxy group-containing compounds or the epoxy group-containing compounds is preferably contained in the sealing film in an amount of from 0.5 to 5.0 parts by mass, especially from 1.0 to 4.0 parts by mass based on 100 parts by mass of the total of EVA and EMMA.

The sealing film of the present invention may further contain antioxidants. Examples of the antioxidants include hindered phenol-type antioxidants such as N,N'-hexane-1,6-diyl-bis[3-(3,5-di-t-butyl-4-hydroxyphenyl) propionamide], phosphorus-type heat stabilizers, lactone-type heat stabilizers, vitamin E-type heat stabilizers and sulfur-type heat stabilizers.

The solar cell sealing film of the present invention can be prepared according to known processes.

The solar cell sealing film can be prepared, for example, by a process in which a composition comprising the above-mentioned materials is molded by using conventional extrusion molding or calendar molding (calendaring) to prepare a product in the form of sheet. Otherwise, the solar cell sealing film can be prepared by dissolving the above-mentioned composition in a solvent to form a solution, applying the solution onto an appropriate support by an appropriate coater and drying it to form a coated film (product in the form of sheet). The heating temperature in the film-formation is preferably selected such that the crosslinker is not reacted or scarcely reacted.

For example, the heating temperature is preferably in the range of from 50 to 90°C, especially from 40 to 80°C. The thickness of the solar cell sealing film, though is not particularly restricted, is preferably in the range of from 0.05 to 2 mm.

The structure of the solar cell is not particularly restricted, as long as the solar cell sealing film according to the invention is used. For example, there can be mentioned a structure comprising a transparent front side protection material, a backside protection material and photovoltaic elements sealed therebetween with the solar cell sealing films of the invention, which is obtained by crosslinking the sealing films and combining them. In the invention, the side (light receiving side) which is exposed to light for photovoltaic elements of a solar cell is referred to as "front side", while the side opposite to the light receiving side of photovoltaic elements of a solar cell is referred to as "backside".

In order to sufficiently seal photovoltaic elements, for example, as shown in Fig. 1, a transparent front side protection material 11, a front side sealing film 13A, photovoltaic elements 14, a backside sealing film 13B and a backside protection material 12 are superposed to prepare a laminate and the laminate is crosslinked and cured according to a conventional process including heating and pressuring steps.

The laminate can be bonded, for example, under the application of pressure and heat by using a vacuum laminator in the conditions of temperature of 135 to 180°C, preferably 140 to 180°C, especially 155 to 180°C, degassing time period of 0.1 to 5 min., pressing pressure of 0.1 to 1.5 kg/cm² and pressing time period of 5 to 15 min. This application of pressure and heat enables EVA and EMMA contained in the front side sealing film 13A and the backside sealing film 13B to crosslink, whereby the photovoltaic elements 14, the transparent front side protection material 11 and the backside protection material 12 are combined through the front side sealing film 13A and the backside sealing film 13B to seal the photovoltaic elements 14.

The solar cell sealing film of the invention can be used in not only solar cells using photovoltaic elements composed of single crystalline or polycrystalline silicon, but also thin-film solar cells such as thin-film silicon-type solar cell, thin-film amorphous silicon-type solar cell and copper selenide-induim (CIS)-type solar cell. Examples of the structures of the thin-film solar cells include the structure that the solar cell sealing film of the invention and a backside protection material are superposed on a thin-film solar cell element which is formed by chemical phase deposition method on a transparent front (light-receiving) side protection material such as a glass plate, a polyimide substrate or a fluoro resin transparent substrate, and the resultant laminate is bonded and united; the structure that the solar cell sealing film of the present invention and a transparent front side protection material are superposed on a thin-film solar cell element which is formed on a backside protection material, and the resultant laminate is bonded and united; or the structure that a transparent front side protection material, the front side sealing film of the present invention, a thin-film solar cell element, the backside sealing film of the present invention and a backside protection material are superposed in this order and the resultant laminate is bonded and united. In the present invention, such photovoltaic elements and thin-film solar cell elements are collectively referred to as photovoltaic elements.

The transparent front side protection material 11 used in the solar cell of the invention is generally a glass plate such as silicate glass. A thickness of the glass plate is generally in the range of 0.1 to 10 mm, preferably 0.3 to 5 mm. The glass plate may be tempered in heat or chemical resistance.

As the backside protection material 12 used in the invention, a plastic film made of polyethylene telephthalate (PET) or polyamides is preferably used. The backside protection material 12 may be a fluorinated polyethylene film (especially a film in which fluorinated polyethylene film/Al/ fluorinated polyethylene film are laminated in this order) from the viewpoint of heat resistance and heat and humidity resistance.

The solar cell (including a thin-film solar cell) of the invention is characterized by the use of the specific sealing films provided on front side and/or backside. Therefore as materials used in components other than the sealing films (i.e., transparent front side protection material, backside protection material, and photovoltaic elements, etc.), those used in a known solar cell can be used, which are not particularly restricted.

The invention is illustrated in more detail by the Examples below.

### Examples

### Preparation of solar cell sealing films

The materials of the formulation set forth in Tables 1 and 2 were introduced into a roll mill and kneaded at 75°C to prepare a composition for a solar cell sealing film. The composition for a solar cell sealing film was subjected to calendaring processing at 80°C and then cooled to give a solar cell sealing film.

### [Evaluation methods]

### 1. Light transmittance (%)

A PET release film (0.075 mm thickness), the solar cell sealing film (0.5 mm thickness) and a PET release film (0.075 mm thickness) were superposed in this order to give a laminate. The laminate was pre-bonded by using a vacuum laminator under the conditions of a temperature of 90°C, a vacuum time of 2 minutes and a pressing time of 8 minutes, and then heat-treated for 45 minutes in an oven whose temperature was set to 155°C to give a sample. The light transmittance spectrums of this sample in the thickness direction were measured at three points by using a spectrometer (U-4000, manufactured by Hitachi, Ltd) to obtain light transmittances at a wavelength range of from 300 to 1,200 nm, and an average of the three measured values was calculated.

### 2. Volume resistivity (Ω·cm)

The solar cell sealing film was cross-linked and cured at a temperature of 155°C for 45 minutes to give a sample. A volume resistivity of this sample after the crosslinking was measured by using HIRESTA-UP from Mitsui Chemicals.

### 3. Cure Torque (N·cm)

5 G of the solar cell sealing film (0.5 mm thickness) was weighed, and this was heated at a temperature of 150°C. The torque value after 15 minutes was measured by reading off it by using Curast Meter from JSR. A cure torque value is a measure exhibiting hardness of a film after cross-linking and curing.

### 4. Haze (%)

A PET release film (0.075 mm thickness), the solar cell sealing film (0.5 mm thickness) and a PET release film (0.075 mm thickness) were superposed in this order to give a laminate. The laminate was pre-bonded by using a vacuum laminator under the conditions of a temperature of 90°C, a vacuum time of 2 minutes and a pressing time of 8 minutes, and then heat-treated for 45 minutes in an oven whose temperature was set to 155°C to give a sample. A haze value of this sample was measured according to JIS K 7105 by using a haze meter from Suga Test Instruments Co., Ltd.

**[Table 1]**

| | | Ex. 1 | Ex. 2 | Ex. 3 | Ex. 4 | Ex. 5 | Ex. 6 | Ex. 7 |
|---|---|---|---|---|---|---|---|---|
| Formulation (parts by mass) | EMMA^{*1} | 10 | 15 | 25 | 50 | 75 | 85 | 90 |
| | EVA^{*2} | 90 | 85 | 75 | 50 | 25 | 15 | 10 |
| | Crosslinker^{*3} | 1.0 | 1.0 | 1.0 | 1.0 | 1.0 | 1.0 | 1.0 |
| | Adhesion improved^{*4} | 0.5 | 0.5 | 0.5 | 0.5 | 0.5 | 0.5 | 0.5 |
| | Crosslinking agent^{*5} | 2.0 | 2.0 | 2.0 | 2.0 | 2.0 | 2.0 | 2.0 |
| Evaluation | Light transmittance (300-1200 nm) | 91.0 | 91.0 | 91.1 | 91 | 91 | 91.1 | 91.1 |
| | Volume resistivity (Ω·cm) | 1E+15 | 1E+15 | 1.5E+15 | 2E+15 | 5E+15 | 7E+15 | 9E+15 |
| | Cure torque (N·cm) | 32.0 | 28.0 | 22.0 | 12.6 | 7.1 | 6.0 | 5.1 |
| | Haze (%) | 0.35 | 0.40 | 0.59 | 0.92 | 1.24 | 1.60 | 1.65 |

| | | | | | | | | |
|---|---|---|---|---|---|---|---|---|
| Note) *1: Acryft WK307 (MMA content: 25% by mass, MFR: 7 g/10min) from Sumitomo Chemical *2: Ultrasen 634 (VA content: 26% by mass, MFR: 4.3 g/10min) from Tosoh *3: 2,5-dimethyl-2,5-di(t-butylperoxy)hexane: Perhexa 25B from NOF Corporation *4: γ-methacryloxypropyltrimethoxysilane : KBM 503 from Shin-Etsu Chemical Co., Ltd *5: Triallyl isocyanurate (TAIC from Nippon Kasei Chemical Company Limited) | | | | | | | | |

**[Table 2]**

| | | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|
| Formulation (parts by mass) | EMMA^{*1} | 100 | 0 | 1 | 9 | 99 | 91 |
| | EVA^{*2} | 0 | 100 | 99.0 | 91.0 | 1 | 9 |
| | Crosslinker^{*3} | 1.0 | 1.0 | 1.0 | 1.0 | 1.0 | 1.0 |
| | Adhesion improved^{*4} | 0.5 | 0.5 | 0.5 | 0.5 | 0.5 | 0.5 |
| | Crosslinking agent^{*5} | 2.0 | 2.0 | 2.0 | 2.0 | 2.0 | 2.0 |
| Evaluation | Light transmittance (300-1200 nm) | 91 | 91.1 | 91 | 91 | 91 | 91 |
| | Volume resistivity (Ω·cm) | 2E+16 | 7E+14 | 7E+14 | 8E+14 | 2E+16 | 1E+16 |
| | Cure torque (N·cm) | 4.8 | 40.4 | 40.2 | 31.5 | 4.8 | 4.9 |
| | Haze (%) | 2.03 | 0.22 | 0.25 | 0.36 | 2.00 | 1.95 |

| | | | | | | | |
|---|---|---|---|---|---|---|---|
| Note) *1-5: as described above. | | | | | | | |

### [Evaluation results]

When the amount of EVA is less than 10 parts by mass and the amount of EMMA is more than 90 parts by mass, the cure torque value is reduced and the haze value is increased. When the amount of EMMA is less than 10 parts by mass and the amount of EVA is more than 90 parts by mass, the volume resistivity is low and thus electric insulation properties are poor. Hence, it is confirmed that the sealing films having the mass ratio (EVA:EMMA) of from 10:90 to 90:10 (Examples 1-7) have high cross-linking properties, high transparency and improved electric insulation properties.

### Description of reference number

- 11: Transparent front side protection material
- 12: Backside protection material
- 13A: Front side sealing film
- 13B: Backside sealing film
- 14: Photovoltaic element
- 15: Connection tab

## Claims

1. A solar cell sealing film comprising ethylene-vinyl acetate copolymer (EVA), ethylene-methyl methacrylate copolymer (EMMA), and a crosslinker,
wherein a mass ratio of the ethylene-vinyl acetate copolymer to the ethylene-methyl methacrylate copolymer (EVA : EMMA) is in the range of from 10:90 to 90:10.

2. The solar cell sealing film according to claim 1, wherein the mass ratio (EVA : EMMA) is in the range of from 75:25 to 10:90.

3. The solar cell sealing film according to claim 1 or 2, wherein the ethylene-methyl methacrylate copolymer has a methyl methacrylate content of from 20 to 35% by mass.

4. The solar cell sealing film according to any one of claims 1 to 3, wherein a volume resistivity after crosslinking is not less than 1E+15 Ω· cm.

5. The solar cell sealing film according to any one of claims 1 to 4, wherein a cure torque value after a crosslinking reaction at a temperature of 150°C for 15 minutes is not less than 5 N·cm.

6. The solar cell sealing film according to any one of claims 1 to 5, wherein the ethylene-vinyl acetate copolymer has a vinyl acetate content of from 20 to 35% by mass.

7. The solar cell sealing film according to any one of claims 1 to 6, wherein the crosslinker is an organic peroxide.

8. The solar cell sealing film according to any one of claims 1 to 7, wherein the crosslinker is contained in an amount of from 0.1 to 5 parts by mass, based on 100 parts by mass of the total of the ethylene-vinyl acetate copolymer and the ethylene-methyl methacrylate copolymer.

9. The solar cell sealing film according to any one of claims 1 to 8, further comprising a crosslinking agent.

10. The solar cell sealing film according to claim 9, wherein the cross-linking agent is contained in an amount of from 0.1 to 5 parts by mass, based on 100 parts by mass of the total of the ethylene-vinyl acetate copolymer and the ethylene-methyl methacrylate copolymer.

11. A solar cell obtained by sealing photovoltaic elements with the solar cell sealing film as defined in any one of claims 1 to 10.

## Patentansprüche

1. Versiegelungsfolie für Solarzellen, umfassend Ethylen-Vinylacetat-Copolymer (EVA), Ethylen-Methylmethacrylat-Copolymer (EMMA) und ein Vernetzungsmittel,
wobei ein Massenverhältnis des Ethylen-Vinylacetat-Copolymers zum Ethylen-Methylmethacrylat-Copolymer (EVA:EMMA) im Bereich von 10:90 bis 90:10 liegt.

2. Versiegelungsfolie für Solarzellen nach Anspruch 1, wobei das Massenverhältnis (EVA:EMMA) im Bereich von 75:25 bis 10:90 liegt.

3. Versiegelungsfolie für Solarzellen nach Anspruch 1 oder 2, wobei das Ethylen-Methylmethacrylat-Copolymer einen Methylmethacrylatgehalt von 20 bis 35 Masse-% aufweist.

4. Versiegelungsfolie für Solarzellen nach irgendeinem der Ansprüche 1 bis 3, wobei ein spezifischer Volumenwiderstand nach dem Vernetzen nicht weniger als 1E + 15 Ω·cm beträgt.

5. Versiegelungsfolie für Solarzellen nach einem der Ansprüche 1 bis 4, wobei ein Aushärtungsmomentwert nach einer Vernetzungsreaktion bei einer Temperatur von 150 °C 15 Minuten lang nicht geringer als 5 N·cm ist.

6. Versiegelungsfolie für Solarzellen nach einem der Ansprüche 1 bis 5, wobei das Ethylen-Vinylacetat-Copolymer einen Vinylacetatgehalt von 20 bis 35 Masse-% aufweist.

7. Versiegelungsfolie für Solarzellen nach einem der Ansprüche 1 bis 6, wobei das Vernetzungsmittel ein organisches Peroxid ist.

8. Versiegelungsfolie für Solarzellen nach einem der Ansprüche 1 bis 7, wobei das Vernetzungsmittel in einer Menge von 0,1 bis 5 Massenteilen, auf 100 Massenteile der Gesamtmenge des Ethylen-Vinylacetat-Copolymers und des Ethylen-Methylmethacrylat-Copolymers bezogen, enthalten ist.

9. Versiegelungsfolie für Solarzellen nach einem der Ansprüche 1 bis 8, ferner ein Vernetzungsmittel umfassend.

10. Versiegelungsfolie für Solarzellen nach Anspruch 9, wobei das Vernetzungsmittel in einer Menge von 0,1 bis 5 Massenteilen, auf 100 Massenteile der Gesamtmenge des Ethylen-Vinylacetat-Copolymers und des Ethylen-Methylmethacrylat-Copolymers bezogen, enthalten ist.

11. Solarzelle, die durch Versiegeln photovoltaischer Elemente mit der Versiegelungsfolie für Solarzellen nach einem der Ansprüche 1 bis 10 erhalten wird.

## Revendications

1. Film d'étanchéité pour pile solaire comprenant un copolymère d'éthylène-acétate de vinyle (EVA), un copolymère d'éthylène-méthacrylate de méthyle (EMMA), et un agent de réticulation,
où un rapport en masse du copolymère d'éthylène-acétate de vinyle au copolymère d'éthylène-méthacrylate de méthyle (EVA:EMMA) se situe dans la plage de 10:90 à 90:10.

2. Film d'étanchéité pour pile solaire selon la revendication 1, où le rapport en masse (EVA:EMMA) se situe dans la plage de 75:25 à 10:90.

3. Film d'étanchéité pour pile solaire selon la revendication 1 ou 2, où le copolymère d'éthylène-méthacrylate de méthyle présente une teneur en méthacrylate de méthyle de 20 à 35 % en masse.

4. Film d'étanchéité pour pile solaire selon l'une quelconque des revendications 1 à 3, où une résistivité volumique après réticulation n'est pas inférieure à 1E + 15 Ω·cm.

5. Film d'étanchéité pour pile solaire selon l'une quelconque des revendications 1 à 4, où une valeur du couple de réticulation après une réaction de réticulation à une température de 150°C durant 15 minutes n'est pas inférieure à 5 N·cm.

6. Film d'étanchéité pour pile solaire selon l'une quelconque des revendications 1 à 5, où le copolymère d'éthylène-acétate de vinyle présente une teneur en acétate de vinyle de 20 à 35 % en masse.

7. Film d'étanchéité pour pile solaire selon l'une quelconque des revendications 1 à 6, où l'agent de réticulation est un peroxyde organique.

8. Film d'étanchéité pour pile solaire selon l'une quelconque des revendications 1 à 7, où l'agent de réticulation est contenu en une quantité de 0,1 à 5 parties en masse, sur la base de 100 parties en masse du total du copolymère d'éthylène-acétate de vinyle et du copolymère d'éthylène-méthacrylate de méthyle.

9. Film d'étanchéité pour pile solaire selon l'une quelconque des revendications 1 à 8, comprenant en outre un agent de réticulation.

10. Film d'étanchéité pour pile solaire selon la revendication 9, où l'agent de réticulation est contenu en une quantité de 0,1 à 5 parties en masse, sur la base de 100 parties en masse du total du copolymère d'éthylène-acétate de vinyle et du copolymère d'éthylène-méthacrylate de méthyle.

11. Pile solaire obtenue par l'étanchéité d'éléments photovoltaïques avec le film d'étanchéité pour pile solaire tel que défini selon l'une quelconque des revendications 1 à 10.
